(19) Europäisches Patentamt
European Patent Office
Office européen des brevets

(11) **EP 3 499 587 A1**

(12) **EUROPEAN PATENT APPLICATION**

(43) Date of publication:
**19.06.2019 Bulletin 2019/25**

(51) Int Cl.:
*H01L 31/0749* (2012.01)     *C23C 14/00* (2006.01)
*C23C 14/14* (2006.01)     *C23C 14/54* (2006.01)

(21) Application number: **18191990.3**

(22) Date of filing: **31.08.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.12.2017   CN 201711353190**

(71) Applicant: **Miasolé Equipment Integration (Fujian) Co., Ltd.**
**362000 Quanzhou Fujian (CN)**

(72) Inventors:
• **QU, Minghao**
**QUANZHOU, Fujian 362000 (CN)**

• **RU, Xiaoning**
**QUANZHOU, Fujian 362000 (CN)**
• **WANG, Yihuan**
**QUANZHOU, Fujian 362000 (CN)**
• **HU, Chao**
**QUANZHOU, Fujian 362000 (CN)**
• **SHU, Yi**
**QUANZHOU, Fujian 362000 (CN)**
• **HU, Pengchen**
**QUANZHOU, Fujian 362000 (CN)**
• **XU, Yongyuan**
**QUANZHOU, Fujian 362000 (CN)**

(74) Representative: **Cabinet Beau de Loménie**
**158, rue de l'Université**
**75340 Paris Cedex 07 (FR)**

(54) **METHOD FOR PREPARING CIGS THIN FILM SOLAR CELL**

(57)    This disclosure provides a method for preparing a CIGS thin film solar cell, including placing a substrate (1) formed with a barrier layer (2) into a sputtering chamber, and forming a doping layer (3) on the barrier layer (2) by sputtering, wherein the doping layer (3) is sodium doped a hetero-molybdenum layer (4); detecting sodium ion content, and introducing water vapor into the sputtering chamber according to the sodium ion content when the doping layer (3) is formed by sputtering. The method for preparing the CIGS thin film solar cell of the present disclosure introduces water vapor into the sputtering chamber according to the content of sodium ions. The water vapor may ensure the stability after sodium ion sputtering, and the content of water vapor is adjusted according to the sodium ion content. The efficiency of sputtering is ensured, and the sodium content in the doping layer (3) is maintained at a reasonable level, so that the CIGS thin film solar cell produced has high efficiency and stable reliability.

Fig.3

EP 3 499 587 A1

**Description**

**TECHNICAL FIELD**

This disclosure relates to a field of solar energy, in particular to a method for preparing a CIGS thin film solar cell.

**BACKGROUND**

In recent years, thin film solar cells represent the development trend of the photovoltaic industry, having advantages of saving materials, increasing production rate, and reducing transportation cost. Among thin film solar cells, the CIGS that is a thin film solar cell of an absorption layer has the most promising development.

It shows from studies that a small amount of Na incorporated into CIGS films can play a role of optimizing performance, and has an irreplaceable role in preparation of high-efficiency CIGS thin film solar cells. An object of doping Na is achieved by the traditional method of using a soda lime glass as a battery substrate. For use of some materials without Na as the substrate, such as various flexible substrate materials, it is required to inject Na into the CIGS film by using appropriate methods, generally by depositing one layer of compounds containing Na such as NaF and NaMoO3 in vacuum before the CIGS layer. The amount of water vapor in the deposition has a great influence on the diffusion and distribution of Na in the CIGS thin film, and thereby affecting efficiency of the battery and reliability of the battery module.

**SUMMARY**

An object of the present disclosure is to provide a method for preparing a CIGS thin film solar cell, which may ensure that the content of doped sodium is kept at a reasonable level, and the produced CIGS thin film solar cell has high efficiency and stable reliability.

The method for preparing a CIGS thin film solar cell of the present disclosure comprises: placing a substrate formed with a barrier layer in a sputtering chamber, and forming a doping layer by sputtering on the barrier layer, wherein the doping layer is a sodium doped molybdenum layer; when the doping layer is formed by sputtering, detecting sodium ion content, and introducing water vapor into the sputtering chamber according to the sodium ion content.

The method as above described, wherein the sodium ion content is detected and the water vapor is introduced into the sputtering chamber according to the sodium ion content, includes:

presetting a minimum threshold A of the sodium ion content, and introducing the water vapor into the sputtering chamber when a sputtering time is longer than or equal to a buffering time T, and when the sodium ion content is detected less than the minimum threshold A.

The method as above described, wherein the sodium ion content is detected and the water vapor is introduced into the sputtering chamber according to the sodium ion content, includes:

presetting a minimum threshold A of the sodium ion content, detecting the sodium ion content in real time, and introducing the water vapor into the sputtering chamber when the sodium ion content is detected to be less than the minimum threshold A.

The method as above described, wherein an amount of the water vapor introduced into the sputtering chamber is nonlinearly and inversely proportional to the sodium ion content.

The method as above described, wherein the sputtering chamber is filled with an inert gas, further includes: detecting the amount of hydrogen ions in the water vapor in the sputtering chamber and the amount of the inert gas ions; and stopping introduction of the water vapor when the ratio of the detected amount of hydrogen ions in the water vapor to the detected amount of inert gas exceeds a preset standard ratio threshold.

The method as above described, wherein the preset standard ratio threshold is 0.1 to 0.4.

The method as above described, wherein the minimum threshold A is $7*10^{19}/cm^3$ to $7.5*10^{19}/cm^3$, and the buffering time T is 5 min to 15 min.

The method as above described, wherein the inert gas is argon.

The method as above described, further includes:

forming subsequent layers on the doping layer after forming the doping layer by sputtering, wherein the subsequent layers comprise in turn a molybdenum layer, an absorption layer, a first buffer layer, a second buffer layer, and a window layer.

The method as above described, wherein the absorbing layer is a mixed layer of copper, indium, gallium, and selenium; the first buffer layer is a cadmium sulfide layer, the second buffer layer is a different zinc oxide layer, and the window layer is an aluminum-doped zinc oxide layer.

According to the method for preparing the CIGS thin film solar cell of the present disclosure, water vapor is introduced into the sputtering chamber according to the content of sodium ions, the water vapor may ensure the stability after sodium ion sputtering, and the content of water vapor is adjusted according to the sodium ion content. Thus, the efficiency of sputtering is ensured, and the sodium content in the doping layer is maintained at a reasonable level, so that the produced CIGS thin film solar cell has high efficiency and stable reliability.

**BRIEF DESCRIPTION OF THE DRAWINGS**

FIG. 1 is a block flow diagram of one embodiment of a method for preparing a CIGS thin film solar cell;
FIG. 2 is a schematic view showing comparison of the water vapor content in the preparation method in the prior art and the preparation method provided in the present application;

FIG. 3 is a schematic structural view of a CIGS thin film solar cell provided by the present disclosure;

FIG. 4 is a comparative graph of sodium ion content in CIGS thin film solar cell during the preparation using the preparation method in the prior art and using the preparation method provided by the present disclosure.

## DETAILED DESCRIPTION

Hereinafter, embodiments of the present disclosure will be described in detail. Examples of the embodiments are shown in the accompanying drawings. The same or similar reference numbers throughout the drawings denote the same or similar elements or elements having the same or similar functions. The embodiments described below with reference to the drawings are exemplary, are merely used to explain the present disclosure, but may not be construed as limiting the present disclosure.

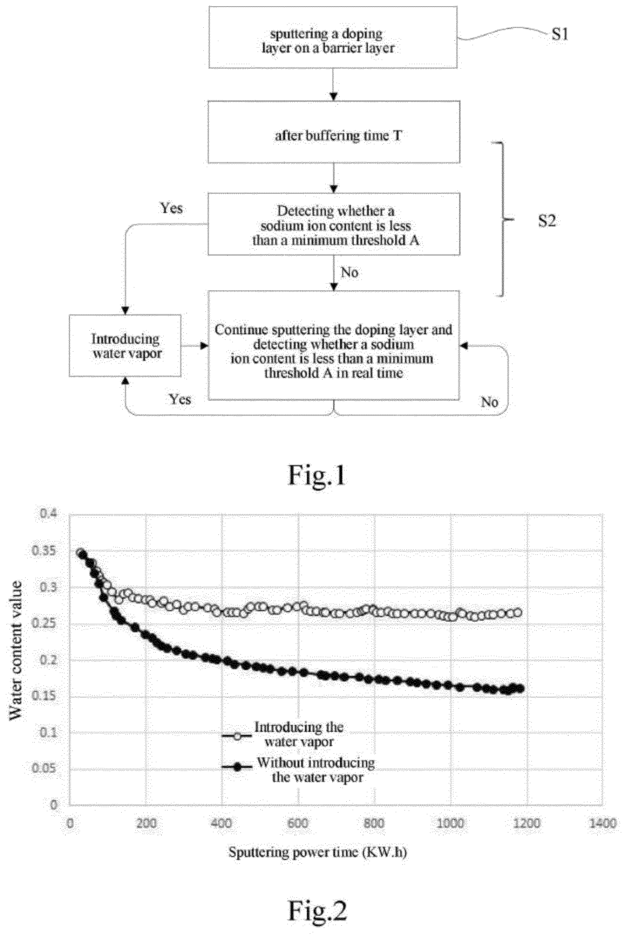

As shown in FIG. 1, the present disclosure discloses a method for preparing a CIGS thin film solar cell. An initial step is to firstly form a barrier layer on a substrate. Step S1 is to put a substrate formed with a barrier layer into a sputtering chamber. Within the sputtering chamber, a doping layer is formed on the barrier layer by the way of sputtering. The doping layer is a sodium doped molybdenum layer, i.e., doped sodium and doped molybdenum sputtered on the barrier layer.

In the preparation of CIGS thin film solar cells (hereinafter abbreviated as CIGS), sputtered sodium may play a role of optimizing the performance. Therefore, in order to ensure the quality of sodium sputtering and stability of the sputtered sodium content, water vapor may be introduced during a process of sodium sputtering, which has a good effect on the stability of the content of sputtered sodium.

In order to effectively utilize the water vapor, when sputtering the doping layer, the sodium ion content is detected, and water vapor is introduced into the sputtering chamber according to the sodium ion content. That is, in step S2 of the method for manufacturing a CIGS thin film solar cell of the present disclosure, when the doping layer is formed by sputtering, the sodium ion content is detected, and the water vapor is introduced into the sputtering chamber according to the sodium ion content. Inductively Coupled Plasma Optical Emission Spectrometer (ICP-OES) may be used to detect the sodium ion content.

Next, relationship between an introduction amount of water vapor and sodium ions in step S2 will be described.

Referring to FIG. 1, in Step S2, a minimum threshold A of sodium ion content is preset. The water vapor is introduced into the sputtering chamber when a sputtering time is longer than or equal to a buffering time T, and the detected sodium ion content is less than the minimum threshold A. That is, at the beginning of sputtering, the sodium content gradually increases, and therefore, it is normal that the sodium ion content in this period does not reach the minimum threshold A. The period of starting sputtering is called the buffering time T. When the sputtering time is longer than or equal to the buffering time T, if the content of sodium ions does not still reach the minimum threshold A, the water vapor will be introduced into the sputtering chamber. The introduction of water vapor is controlled by a needle valve or mass flow controller (MFC), of course, the amount of water vapor is also controlled at the same time.

In another embodiment, step S2 includes: presetting a minimum threshold value A of sodium ion content, detecting the sodium ion content in real time, and introducing the water vapor into the sputtering chamber when the content of sodium ion is detected less than the minimum threshold A. That is, the sodium ion content is directly detected without setting the buffering time T. In this case, the water vapor is generally introduced at the initial stage of sputtering, which may increase the amount of sodium ions at the initial sputtering stage.

The aforesaid two embodiments may have difference only in the buffering time T, but may be completely the same on other aspects.

The above-mentioned detection of sodium ion content using ICP-OES is only a preferable method, which is direct detection (also monitoring of sodium ions). However, other methods for detecting sodium ions may also be used in the present disclosure. Specific detection methods will be omitted in the present disclosure.

Next, in one embodiment, if the sputtering time is longer than or equal to the buffering time T, and the sodium ion content is detected greater than or equal to the minimum threshold A. Alternatively, in another embodiment, if the sodium ion content as detected in real time is greater than or equal to the minimum threshold A, the water vapor may not be introduced. In the embodiment of the real-time detection, the water vapor is generally introduced at the initial sputtering stage, if the requirements are satisfied in the subsequent stages, the introduction of the water vapor may be stopped.

Optionally, the minimum threshold A is $7*10^{19}/cm^3$ to $7.5*10^{19}/cm^3$, and the buffering time T is 5min to 15min.

In summary, the method is presented as follows: sputtering the doping layer on the barrier layer in the sputtering chamber, after the buffering time T, detecting whether the sodium ion content is less than the minimum threshold A, if the sodium ion content is not less than the minimum threshold A, the sputtering the dosing layer will continue and the sodium ion content will be detected in real time; if the sodium ion content is less than the minimum threshold A, the water vapor will be introduced into the sputtering chamber to perform sputtering. Of course, the sodium ion content will also be detected in real time in the sputtering operation after the water vapor is introduced.

That is to say, after the buffering time T has elapsed, the sodium ion content is detected in real time during the sputtering no matter whether or not the water vapor is supplied. And during the sodium ion content is monitored in the real time, if the detected sodium ion is detected not less than the minimum threshold A, the sputtering will continue according to the current mode, and if the sodium ion content is detected less than the minimum threshold A, the water vapor will be introduced until the sodium ion content reaches the minimum threshold A.

In another embodiment, whether the sodium ion content is less than the minimum threshold A is detected in the real time. If the sodium ion content is not less than the minimum threshold A, the sputtering the dosing layer will continue and the sodium ion content is detected in the real time. If the sodium ion content is less than the minimum threshold A, the water vapor is introduced into the sputtering chamber to perform sputtering. Of course, the sodium ion content is also detected in the real time in the sputtering operation after the water vapor is introduced.

The water vapor may increase an amount of sodium ions sputtered on the barrier layer. As above described, the water vapor is introduced when the amount of sodium ions is small, and the introduction of the water vapor may be stopped when reaching the minimum threshold value A. It can be seen that the amount of water vapor is inversely proportional to the amount of sodium ions. Further, the inverse proportion is an inversely nonlinear proportion.

As an example, the amount of the water vapor introduced into the sputtering chamber is Y, the detected sodium ion content is X, and a formula of the amount of the water vapor introduced into the sputtering chamber and the detected sodium ion content is:

$$Y = \frac{K}{X}$$

Wherein, K is a preset standard parameter. The standard parameter K is determined according to different sputtering requirements, such as different sodium ion content, or different filling gas (inert gas) content in the sputtering chamber. Of course, the standard parameter K is a non-zero positive number, such that the amount of the water vapor introduced into the sputtering chamber is inversely proportional to the amount of the detected sodium ions. Also, since the amount of the water vapor is inversely proportional to the amount of the detected sodium ions, the value K may not be a fixed value, but may also be a function having a certain variable.

The sputtering chamber is filled with an inert gas such as helium, argon and the like. The argon is optionally used in the present disclosure.

Hereinafter, detection of the amount of the water vapor is described: the amount of hydrogen ions of the water vapor and the amount of inert gas ions in the sputtering chamber are detected. When the ratio of the amount of hydrogen ions in the water vapor to the amount of the detected inert gas ions exceeds a preset standard ratio threshold, the introduction of the water vapor is stopped. The preset standard ratio threshold is 0.1-0.4. For ease of understanding, the amount of the hydrogen ions in the water vapor is defined as first ion amount, and the amount of the inert gas ions is defined as second ion amount (in the preferable embodiment, the amount of the inert gas ions may be the amount of argon ions). If the ratio of the first ion amount to the second ion amount is larger than 0.04 (the preset standard ratio threshold), the introduction of the water vapor will be stopped.

ICP-OES may also be used to obtain the first ion amount and the second ion amount. It should be noted that the water vapor in the sputtering chamber is not introduced completely through the needle valve or the MFC.

In addition to the needle valve or the MFC, there are two further sources for introducing the water vapor, that is to say, detecting the amount of the hydrogen ions in the water vapor, what is detected is not the water vapor introduced completely through the needle valve or the MFC. The water vapor may further have two sources below: one of the sources may be a target itself which has moisture, for example, the target made of sodium molybdate absorbs water by itself; and the other source may be water absorbed onto the walls of the sputtering chamber as opening the sputtering chamber in repeated experiments.

With reference to FIG. 2, the content of water in the sputtering chamber when no needle valve or MFC is used to introduce the water vapor is shown, and also the content of the water vapor when using the above method of the present disclosure is also shown. Of course, the content of the water vapor as shown in FIG. 2 is determined by the ratio of the first ion amount to the second ion amount.

It may be understood that the standard ratio has the highest value, and it is generally impossible to introduce water vapor in an infinite amount. The standard ratio limits the ratio of the water vapor to the inert gas so as to achieve the best sputtering effect.

By means of the foregoing method, a barrier layer 2 is formed on the substrate 1, and the doping layer 3 is formed on the barrier layer 2 by sputtering, and then a subsequent layer is formed on the doping layer 3; the subsequent layer comprises a molybdenum layer 4, an absorption layer 5, a first buffer layer 6, a second buffer layer 7, and a window layer 8 formed in sequence. The absorption layer 5 is a mixed layer of copper, indium, gallium, and selenium. The first buffer layer 6 is a cadmium sulfide layer. The second buffer layer 7 is a different zinc oxide layer. The window layer 8 is an aluminum-doped zinc oxide layer. The structure as shown in FIG.

3 is thereby obtained.

Optionally, the barrier layer 2 is firstly formed on the substrate 1 as above mentioned, and the barrier layer 2 may be a titanium layer or a molybdenum layer or a titanium-molybdenum mixed layer.

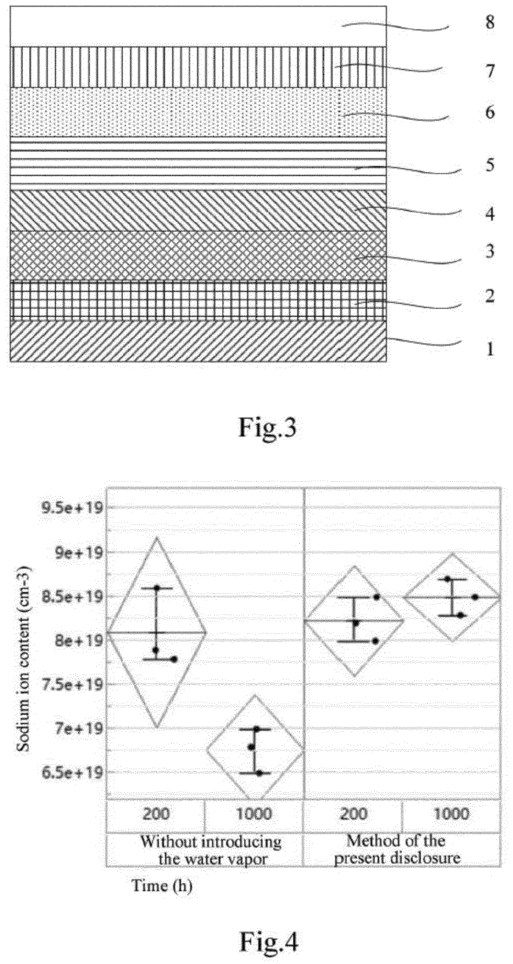

In addition, referring to FIG. 4, the results of different variations in the sodium ion content when sputtering is performed without the introduction of the water vapor by using the above method of the present disclosure is shown. From the comparison results, it can be seen that the method for preparing the CIGS thin film solar cell provided by the present disclosure may ensure that the content of doped sodium is maintained at a reasonable level, and the CIGS thin film solar cell has high efficiency and stable reliability. The structure, features, and effects of the present disclosure have been described in detail with reference to the embodiments as shown in the drawings. The above description is only the optional embodiments of the present disclosure, but the present disclosure does not limit the scope of implementation as shown in the drawings. Any change made to conception of the present disclosure, or equivalent embodiments that are modified to equivalent variations, should still fall within the protection scope of the present disclosure if they do not exceed the spirit covered by the description and the drawings.

**Claims**

1. A method for preparing a CIGS thin film solar cell, comprising:

   placing a substrate (1) formed with a barrier layer (2) in a sputtering chamber, and forming a doping layer (3) on the barrier layer (2) by sputtering, wherein the doping layer (3) is a sodium doped molybdenum layer (4);
   detecting a sodium ion content and introducing water vapor into the sputtering chamber according to the sodium ion content when the doping layer (3) is formed by sputtering.

2. The method according to claim 1, further comprising:

   presetting a minimum threshold A of the sodium ion content, and introducing the water vapor into the sputtering chamber when a sputtering time is longer than or equal to a buffering time T, and when the sodium ion content is detected less than the minimum threshold A.

3. The method according to claim 1, further comprising:

   presetting a minimum threshold A of the sodium ion content, detecting the sodium ion content in real time, and introducing the water vapor into the sputtering chamber when the sodium ion content is detected less than the minimum threshold A.

4. The method according to any one of claims 1 to 3, wherein an amount of the water vapor introduced into the sputtering chamber is nonlinearly and inversely proportional to the sodium ion content.

5. The method according to claim 1, wherein the sputtering chamber is filled with an inert gas, said method further comprising:

   detecting an amount of hydrogen ions of the water vapor and an amount of the inert gas ions in the sputtering chamber;
   stopping introduction of the water vapor when the ratio of the detected amount of hydrogen ions in the water vapor to the detected amount of inert gas exceeds a preset standard ratio threshold.

6. The method according to claim 5, wherein the preset standard ratio threshold is 0.1 to 0.4.

7. The method according to claim 2, wherein the minimum threshold A is $7*10^{19}/cm^3$ to $7.5*10^{19}/cm^3$, and the buffering time T is 5min to 15min.

8. The method according to claim 5 or 6, wherein the inert gas is argon.

9. The method according to anyone of claims 1 to 8, further comprising:

   forming subsequent layers on the doping layer (3) after forming the doping layer (3) by sputtering;
   wherein the subsequent layers comprise in turn a molybdenum layer (4), an absorption layer (5), a first buffer layer (6), a second buffer layer (7), and a window layer (8).

10. The method according to claim 9, wherein the absorbing layer is a mixed layer of copper, indium, gallium, and selenium;
    the first buffer layer (6) is a cadmium sulfide layer, the second buffer layer (7) is a different zinc oxide layer, and the window layer (8) is an aluminum-doped zinc oxide layer.

EP 3 499 587 A1

Fig.1

Fig.2

Fig.3

Fig.4

Europäisches
Patentamt

European
Patent Office

Office européen
des brevets

# EUROPEAN SEARCH REPORT

**Application Number**

EP 18 19 1990

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LORELLE M MANSFIELD ET AL: "Sodium-doped molybdenum targets for controllable sodium incorporation in CIGS solar cells", PHOTOVOLTAIC SPECIALISTS CONFERENCE (PVSC), 2011 37TH IEEE, IEEE, 19 June 2011 (2011-06-19), pages 3636-3641, XP032167681, DOI: 10.1109/PVSC.2011.6185937 ISBN: 978-1-4244-9966-3 * abstract * * page 3636, left-hand column, paragraph 2 - page 3638; figures 1-5; table 1 * * page 3640, right-hand column, paragraph 1; figure 8; table 2 * | 1-10 | INV. H01L31/0749 C23C14/00 C23C14/14 C23C14/54 |
| A | AT 10 578 U1 (PLANSEE METALL GMBH [AT]) 15 June 2009 (2009-06-15) * page 2, line 1 - line 50 * * page 3, line 50 - page 6, line 40 * | 1-10 | |
| A | EP 1 862 563 A2 (WUERTH SOLAR GMBH & CO KG [DE]) 5 December 2007 (2007-12-05) * paragraphs [0002], [0004], [0008] - paragraph [0014] * * paragraphs [0017], [0021], [0026], [0034], [0035]; figure 1 * | 1-10 | TECHNICAL FIELDS SEARCHED (IPC) H01L C23C |
| A | US 2015/114466 A1 (AHN SEOUNGKYU [KR] ET AL) 30 April 2015 (2015-04-30) * paragraph [0014] - paragraph [0034] * * paragraph [0047] - paragraph [0054]; figure 1 * * paragraph [0064] - paragraph [0067]; examples 1-3 * | 1-10 | |

-/--

The present search report has been drawn up for all claims

| Place of search | Date of completion of the search | Examiner |
|---|---|---|
| Berlin | 26 February 2019 | Hofmann, Kerrin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 18 19 1990

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 8 241 943 B1 (WIETING ROBERT D [US] ET AL) 14 August 2012 (2012-08-14)<br>* column 1, line 40 - column 3, line 6 *<br>* column 3, line 55 - column 8, line 53; figures 1-6A * | 1-10 | |
| | ----- | | |

TECHNICAL FIELDS
SEARCHED        (IPC)

The present search report has been drawn up for all claims

| Place of search | Date of completion of the search | Examiner |
|---|---|---|
| Berlin | 26 February 2019 | Hofmann, Kerrin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 18 19 1990

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2019

| Patent document cited in search report | | Publication date | Patent family member(s) | | Publication date |
|---|---|---|---|---|---|
| AT 10578 | U1 | 15-06-2009 | AT | 10578 U1 | 15-06-2009 |
| | | | CN | 101918604 A | 15-12-2010 |
| | | | EP | 2227573 A2 | 15-09-2010 |
| | | | JP | 5450441 B2 | 26-03-2014 |
| | | | JP | 2011507281 A | 03-03-2011 |
| | | | KR | 20100097194 A | 02-09-2010 |
| | | | US | 2010269907 A1 | 28-10-2010 |
| | | | WO | 2009076690 A2 | 25-06-2009 |
| EP 1862563 | A2 | 05-12-2007 | AT | 503857 T | 15-04-2011 |
| | | | DE | 102006026672 A1 | 06-12-2007 |
| | | | EP | 1862563 A2 | 05-12-2007 |
| | | | ES | 2362439 T3 | 05-07-2011 |
| US 2015114466 | A1 | 30-04-2015 | KR | 20140021971 A | 21-02-2014 |
| | | | US | 2015114466 A1 | 30-04-2015 |
| | | | WO | 2014025176 A1 | 13-02-2014 |
| US 8241943 | B1 | 14-08-2012 | NONE | | |

EPO FORM P0459

For more details about this annex : see Official Journal of the European Patent Office, No. 12/82